Europäisches Patentamt

European Patent Office

Office européen des brevets

(11) Veröffentlichungsnummer: **0 282 826 B1**

(12) **EUROPÄISCHE PATENTSCHRIFT**

(45) Veröffentlichungstag der Patentschrift: **18.12.91**

(51) Int. Cl.5: **H01L 25/04, H01L 31/02**

(21) Anmeldenummer: 88103237.9

(22) Anmeldetag: 03.03.88

(54) **Solarzellenmodul mit parallel und seriell angeordneten Solarzellen.**

(30) Priorität: **17.03.87 DE 3708548**

(43) Veröffentlichungstag der Anmeldung:
**21.09.88 Patentblatt 88/38**

(45) Bekanntmachung des Hinweises auf die
Patenterteilung:
**18.12.91 Patentblatt 91/51**

(84) Benannte Vertragsstaaten:
**DE ES FR GB GR IT**

(56) Entgegenhaltungen:
**DE-A- 1 213 749**
**GB-A- 2 040 562**
**US-A- 3 433 676**

**TWELFTH IEEE PHOTOVOLTAIC SPECIA-
LISTS CONFERENCE, Baton Rouge, Louisiana, Seiten 375-378, 15-18 November 1976;
R.A. PRYOR et al.: "A novel solar cell interconnection design"**

(73) Patentinhaber: **TELEFUNKEN SYSTEMTECHNIK
GMBH
Sedanstrasse 10
W-7900 Ulm (Donau)(DE)**

(72) Erfinder: **Flödl, Helmut, Dipl.-Ing.
Wittstatt-Weg 6
W-7107 Bad Friedrichshall(DE)**

(74) Vertreter: **Schulze, Harald Rudolf, Dipl.-Ing.
TELEFUNKEN SYSTEMTECHNIK GMBH Sedanstrasse 10
W-7900 Ulm(DE)**

**Beschreibung**

Die Erfindung betrifft ein Solarzellenmodul aus überlappend angeordneten und elektrisch miteinander in der Überlappungszone verbundenen Solarzellen. Diese als Solarzellenmodul aufgebauten Solarzellen sind zur Erreichung der erforderlichen Spannung in Serie geschaltet. Aus der DE-A-12 13 749 ist eine solche Anordnung bekannt. Zur Erzeugung größerer Stromstärken müssen mehrere Module parallel geschaltet werden, wobei inaktive Flächen zwischen benachbarten Modulen entstehen, die den Gesamtwirkungsgrad der Anordnung wesentlich verschlechtern. Außerdem erfolgte bisher die Verschaltung mehrerer Solarzellenmodule zu einem Solarzellengenerator mit einem relativ teuren Herstellungsverfahren.

Der Erfindung liegt die Aufgabe zugrunde, ein Solarzellenmodul anzugeben, dessen Solarzellen sowohl parallel als auch seriell so verschaltet werden können, daß die Solarzellen in extrem flächensparender Weise angeordnet und verschaltet sind.

Diese Aufgabe wird bei einem Solarzellenmodul der eingangs beschriebenen Art erfindungsgemäß dadurch gelöst, daß die aus mindestens zwei Solarzellen bestehenden Solarzellenzeilen derartig überlappend angeordnet werden, daß die durch die Aneinanderreihung von Solarzellen zu einer Solarzellenzeile entstehenden Stoßfugen gegenüber jenen in benachbarten Solarzellenzeilen versetzt sind.

Die durch die erfindungsgemäße Anordnung der Solarzellen gegebene Möglichkeit, die Solarzellen nicht nur in Reihe, sondern auch innerhalb des Solarmoduls parallel zu verschalten, führt dazu, daß alle erforderlichen Strom-Spannungsverhältnisse verwirklicht werden können, ohne zusätzlichen Schaltungsaufwand durchführen und ohne zusätzliche Fläche bereitstellen zu müssen. Hierdurch wird höchste Packungsdichte der Solarzellen erreicht, da unter anderem für das Verschalten der Zellen keine inaktive Fläche benötigt wird, wodurch der Wirkungsgrad der erfindungsgemäßen Solarzellenmodule von typischerweise 9,5 % bei üblichen zu Solarzellengeneratoren zusammengeschalteten Solarzellenmodulen auf über 11 % gesteigert wird. Ein weiterer Vorteil besteht darin, daß sehr große Zellenflächen mit einer Fläche von über 100 cm² hergestellt werden können, wobei durch den erfindungsgemäßen starren Verband während des Moduleinbettungsprozesses keine Verschiebung der einzelnen Solarzellen gegeneinander möglich ist, wodurch auch die bei üblicher Verschaltung möglicherweise entstehenden Unterbrechungen der Verbindungsleitungen benachbarter Solarzellenmodule nicht auftreten können. Darüber hinaus erlaubt die einfache Herstellung der erfindungsgemäßen Solarzellenmodule eine wesentliche Senkung der Produktionskosten.

Weitere vorteilhafte Ausgestaltungen der Erfindung ergeben sich aus den Unteransprüchen.

Die Erfindung und ihre Ausgestaltung soll nachstehend noch anhand eines Ausführungsbeispieles dargestellt werden.

Die Figur 1 zeigt in perspektivischer Ansicht eine Ausführungsform des erfindungsgemäßen Solarzellenmoduls.

Figure 2 zeigt im Schnitt die Ausführungsform des erfindungsgemäßen Solarzellenmoduls nach Figur 1.

Bei dem dargestellten Ausführungsbeispiel sind fünf Solarzellenzeilen 2 überlappend angeordnet, wobei die Solarzellenzeilen 2 jeweils abwechselnd aus drei oder vier aneinandergereihten Solarzellen 1, beispielsweise aus polykristallinem Silizium, mit ganzflächig metallisierten Rückseiten bestehen, wozu zwei Sorten von Solarzellen Verwendung finden, die sich nur in ihrer Länge unterscheiden. Hierzu wird beispielsweise eine Solarzelle mit den Abmessungen 10 cm x 10 cm in der Mitte geteilt, wodurch zwei länglich rechteckförmige Solarzellen, als erste Sorte bezeichnet, entstehen. Die zweite Sorte von Solarzellen wird durch mittiges Teilen der Längsseite der ersten Sorte hergestellt. Die Solarzellen 1 der ersten und zweiten Sorte unterscheiden sich bei gleicher Breite nur in der Länge, wobei die Solarzellen der ersten Sorte doppelt so lang wie die der zweiten Sorte sind.

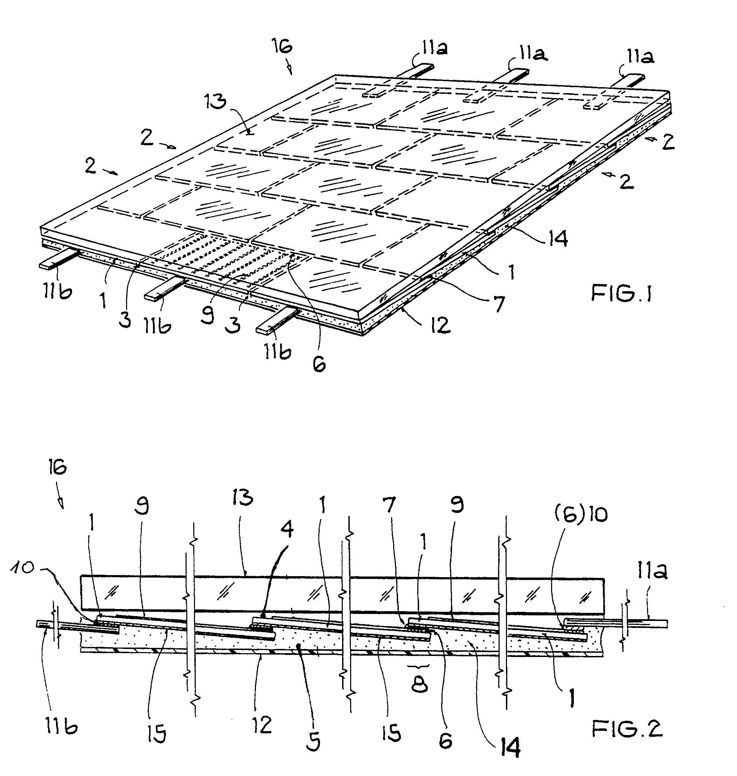

Die nach Figur 1 am linken unteren Rand des Solarzellenmoduls sich befindende Solarzellenzeile, als erste Solarzellenzeile bezeichnet, besteht aus drei aneinandergereihten Solarzellen 1 gleicher Länge der ersten Sorte, wodurch zwei Stoßfugen 3 entstehen. Am äußeren Rand der Rückseite dieser ersten Solarzellenzeile 2 sind die Anschlußkontakte 11b angeordnet und diametral gegenüberliegend befindet sich am äußeren Rand der Vorderseite dieser ersten Solarzellenzeile der Kontaktsteg 6, der mit den senkrecht dazu verlaufenden Kontaktfingern 9 auf den Solarzellen verbunden ist. Die angrenzende Solarzellenzeile, als zweite Solarzellenzeile bezeichnet, besteht aus je zwei Solarzellen der zweiten und der ersten Sorte, in der Weise angeordnet, daß die längeren Solarzellen direkt aneinandergereiht zwischen den beiden kürzeren liegen, wodurch drei Stoßfugen 3 entstehen. Um die beiden Solarzellenzeilen in der erfindungsgemäßen Art miteinander zu verlöten, wird nach dem Herstellen der Kontaktfinger 9 und der Kontaktstege 6 der Solarzellen im Siebdruckverfahren auf die Kontaktstege 6 mit dem gleichen Verfahren Lotpaste 7, beispielsweise SnPb(36)Ag(2) aufgebracht, wodurch die Überlappungszone 8 von ca. 1 mm Breite definiert wird.

Die Verschaltung der beiden Solarzellenzeilen 2 erfolgt dadurch, daß die zweite Solarzellenzeile 2 schindelartig im Bereich der Überlappungszone 8 mittels eines Lötverfahrens, beispielsweise Erwärmung in einem Infrarot-Durchlaufofen, mit der ersten Solarzellenzeile 2 verbunden wird, in der Weise, daß die drei Stoßfugen der zweiten Solarzellenzeile je mittig an den Längsseiten der drei Solarzellen der ersten Solarzellenzeile liegen und umgekehrt die beiden Stoßfugen 3 der ersten Zeile mittig an den Längsseiten der beiden mittleren Solarzellen der zweiten Solarzellenzeile liegen.

Aufgrund der durchgehenden Kontaktstege 6 der ersten Solarzellenzeile liegen die Rückseiten der Solarzellen der zweiten Solarzellenzeile auf gleichem Potential, und umgekehrt werden durch die rückseitige Metallisierung 15 der Solarzellen der zweiten Solarzellenzeile die Vorderseiten der Solarzellen der ersten Solarzellenzeile ebenso auf gleiches Potential gelegt.

Wie aus Figur 1 ersichtlich wird, ist die an die zweite Solarzellenzeile angrenzende dritte Solarzellenzeile, bestehend aus drei Solarzellen der ersten Sorte, in der gleichen Art und Weise wie oben beschrieben mit der zweiten Solarzellenzeile verlötet, wobei auch hier die Stoßfugen mittig an die Längsseiten der mittleren Solarzellen der zweiten Solarzellenzeile liegen und die Vorderseiten der Solarzellen der zweiten Solarzellenzeile auf gleichem Potential liegen.

In dieser Weise fortfahrend, abwechselnd Solarzellenzeilen mit drei bzw. vier Solarzellen zu verwenden, wird ein erfindungsgemäßer Solarzellenmodul, entsprechend Figur 1, aufgebaut. Die auftretenden Stoßfugen benachbarter Solarzellenzeilen 2 sind gegeneinander versetzt, wodurch erreicht wird, daß die Solarzellen 1 einer Solarzellenzeile 2 parallel geschaltet sind. Weiterhin wird aus der Figur 2 der schindelartige Aufbau deutlich, wodurch gleichzeitig die Reihenschaltung der Solarzellenzeilen erfolgt. Die Anschlußkontakte 11a, 11b werden am Kontaktsteg 10, der sich am Rand der Vorderseite der letzten Solarzellenzeile befindet sowie am äußeren Rand der metallisierten Rückseite 15 der ersten Solarzellenzeile angebracht. Das aus parallel und seriell verschalteten Solarzellen 1 aufgebaute Solarzellenpanel 16 ist in Kunststoff 14, beispielsweise EVA, eingebettet und an der Rückseite 5 mit einer Aluminiumfolie 12 abgeschlossen. Als Trägerplatte dient die auf der Vorderseite 4 angeordnete Glasplatte 13.

Das in Figur 1 und 2 beschriebene Ausführungsbeispiel der Erfindung kann dahingehend an geforderte Strom/Spannungsverhältnisse angepaßt werden, indem sowohl die Anzahl der in den Solarzellenzeilen parallel geschalteten Solarzellen als auch die in Serie geschalteten Solarzellenzeilen entsprechend diesen Strom/Spannungsverhältnissen geändert werden.

**Patentansprüche**

1. Solarzellenmodul aus überlappend angeordneten und elektrisch miteinander in der Überlappungszone verbundenen Solarzellen, dadurch gekennzeichnet, daß die aus mindestens zwei Solarzellen (1) bestehenden Solarzellen-Zeilen (2) derart überlappend angeordnet werden, daß die durch die Aneinanderreihung von Solarzellen (1) zu einer Solarzellen-Zeile (2) entstehenden Stoßfugen (3) gegenüber jenen in benachbarten Solarzellen-Zeilen (2) gegeneinander versetzt sind.

2. Solarzellenmodul nach Anspruch 1, dadurch gekennzeichnet, daß die an der Vorderseite (4) und die an der diametral gegenüberliegende Rückseite (5) auf der ganzen Länge des Solarzellen-Zeile durchgehenden Überlappungszonen (8) zur Kontaktierung sowohl der in den Solarzellen-Zeilen (2) aneinandergereihten Solarzellen (1) als auch der aufeinanderfolgenden Solarzellen-Zeilen (2) dient, in der Weise, daß die in den Solarzellen-Zeilen (2) aneinandergereihten Solarzellen (1) auf gleichem Potential liegen und somit parallel verschaltet sind und die aneinandergereihten Solarzellen-Zeilen (2) seriell geschaltet sind.

3. Solarzellenmodul nach Anspruch 1, dadurch gekennzeichnet, daß die Serien/Parallelschaltung aus Solarzellen an ihren beiden Enden mit Stromabführungskontakten (11a, 11b) versehen ist.

4. Solarzellenmodul nach einem der vorangehenden Ansprüche, dadurch gekennzeichnet, daß die Kontaktierung der Solarzellen-Zeilen (2) an den Überlappungszonen (8) durch Löten erfolgt.

**Claims**

1. Solar cell module of solar cells arranged to be overlapping and electrically connected with one another in the zones of overlapping, characterised thereby that the solar cell lines (2) consisting of at least two solar cells (1) are arranged to be overlapping in such a manner that the expansion joints (3) resulting from the lining up of solar cells (1) into a solar cell line (2) are offset relative to one another compared with those in neighbouring solar cell lines (2).

2. Solar cell module according to claim 1, characterised thereby that the zones (8) of overlapping, which extend over the entire length of the solar cell lines at the front side (4) and at the diametrically opposite back side (5), serve for contact-making not only of the solar cells (1) lined up into the solar cell lines (2) but also of the successive solar cell lines (2) in the manner that the solar cells (1) lined up into the solar cell lines (2) lie at the same potential and are thus connected in parallel and the lined up solar cell lines (2) are connected in series.

3.  Solar cell module according to claim 1, characterised thereby that the serial/parallel connection of solar cells is provided at both its ends with current take-off contacts (11a, 11b).

4.  Solar cell module according to one of the preceding claims, characterised thereby that the contacting of the solar cell lines (2) at the zones of overlapping is effected through soldering.

**Revendications**

1.  Module de cellules solaires constitué par des cellules solaires agencées avec chevauchement et reliées électriquement dans la zone de chevauchement, caractérisé par le fait que les lignes (2) de cellules solaires, constituées d'au moins deux cellules solaires (1), sont agencées avec chevauchement de manière que les joints (3) résultant de la mise en rang de cellules solaires (1) pour constituer une ligne (2) de cellules solaires soient décalés par rapport à ceux dans des lignes (2) voisines.

2.  Module de cellules solaires selon revendication 1, caractérisé par le fait que les zones de chevauchement (8), continues sur toute la longueur des lignes de cellules solaires, situées sur le côté avant (4) et celles situées sur le côté arrière diamétralement opposé (5), servent au contact de connexion des cellules solaires (1) disposées en rang dans les lignes (2) de cellules solaires, aussi bien que des lignes consécutives (2) de cellules solaires, et cela de manière que les cellules solaires (1) disposées en rang dans les lignes de cellules solaires (2) se trouvent au même potentiel et soient ainsi branchées en parallèle, et que les lignes (2) de cellules solaires disposées en rang soient brancnées en série.

3.  Module de cellules solaires selon revendication 1, caractérisé par le fait que le circuit série/parallèle constitué de cellules solaires est muni, en ses deux sorties, de contacts de sortie de courant (11a, 11b).

4.  Module de cellules solaires selon l'une des revendications précédentes, caractérisé par le fait que la mise en contact de connexion des lignes (2) de cellules solaires, à l'endroit des zones de chevauchement (8), est réalisée par soudage.

FIG.1

FIG.2